# EUROPEAN PATENT APPLICATION

(11) **EP 1 935 954 A1**
(43) Date of publication of application: **25.06.2008**
(21) Application number: 07123953.7
(22) Date of filing: 21.12.2007
(51) Int. Cl.: C09G 1/02, C09K 3/14, H01L 21/321, B24B 37/04

(54) **Compositions for chemical mechanical planarization of copper**

(30) Priority: 21.12.2006 US 643309
(71) Applicant: DuPont Air Products NanoMaterials L.L.C., Tempe, AZ 85282 (US)
(72) Inventor: Siddiqui, Junaid Ahmed, Richmond, AZ 23234 (US); McConnell, Rachel Dianne, Mesa,, AZ 85204 (US); Usmani, Saifi, Phoenix, AZ 85045 (US)
(74) Representative: Muir, Benjamin M. J.

(57) **Abstract**

A composition and associated method for chemical mechanical planarization of a copper-containing substrate are described and which afford low defectivity levels on copper during copper CMP processing. The composition comprises a colloidal silica that is substantially free of soluble polymeric silicates.

## Description

### BACKGROUND OF THE INVENTION

This invention relates generally to the chemical-mechanical planarization (CMP) of metal substrates (e.g., copper substrates) on semiconductor wafers and slurry compositions therefor. In particular, the present invention relates to a CMP slurry composition that is effective for use in copper CMP and which affords low defectivity levels on polished substrates following CMP processing. This invention is especially useful for step 2 copper CMP where low defectivity levels on planarized substrates are desired.

Chemical mechanical planarization (chemical mechanical polishing, CMP) for planarization of semiconductor substrates is now widely known to those skilled in the art and has been described in numerous patents and open literature publications. An introductory reference on CMP is as follows: "Chemical-Mechanical Polish" by G. B. Shinn et al., Chapter 15, pages 415-460, in Handbook of Semiconductor Manufacturing Technology, editors: Y. Nishi and R. Doering, Marcel Dekker, New York City (2000).

In a typical CMP process, a substrate (e.g., a wafer) is placed in contact with a rotating polishing pad attached to a platen. A CMP slurry, typically an abrasive and chemically reactive mixture, is supplied to the pad during CMP processing of the substrate. During the CMP process, the pad (fixed to the platen) and substrate are rotated while a wafer carrier system or polishing head applies pressure (downward force) against the substrate. The slurry accomplishes the planarization (polishing) process by chemically and mechanically interacting with the substrate film being planarized due to the effect of the rotational movement of the pad relative to the substrate. Polishing is continued in this manner until the desired film on the substrate is removed with the usual objective being to effectively planarize the substrate. Typically metal CMP slurries contain an abrasive material, such as silica or alumina, suspended in an oxidizing, aqueous medium.

Silicon based semiconductor devices, such as integrated circuits (ICs), typically include a dielectric layer, which can be a low-k dielectric material, silicon dioxide, or other material. Multilevel circuit traces, typically formed from aluminum or an aluminum alloy or copper, are patterned onto the low-k or silicon dioxide substrate.

CMP processing is often employed to remove and planarize excess metal at different stages of semiconductor manufacturing. For example, one way to fabricate a multilevel copper interconnect or planar copper circuit traces on a silicon dioxide substrate is referred to as the damascene process. In a semiconductor manufacturing process typically used to form a multilevel copper interconnect, metallized copper lines or copper vias are formed by electrochemical metal deposition followed by copper CMP processing. In a typical process, the interlevel dielectric (ILD) surface is patterned by a conventional dry etch process to form vias and trenches for vertical and horizontal interconnects and make connection to the sublayer interconnect structures. The patterned ILD surface is coated with an adhesion-promoting layer such as titanium or tantalum and/or a diffusion barrier layer such as titanium nitride or tantalum nitride over the ILD surface and into the etched trenches and vias. The adhesion-promoting layer and/or the diffusion barrier layer is then overcoated with copper, for example, by a seed copper layer and followed by an electrochemically deposited copper layer. Electrodeposition is continued until the structures are filled with the deposited metal. Finally, CMP processing is used to remove the copper overlayer, adhesion-promoting layer, and/or diffusion barrier layer, until a planarized surface with exposed elevated portions of the dielectric (silicon dioxide and/or low-k) surface is obtained. The vias and trenches remain filled with electrically conductive copper forming the circuit interconnects.

When one-step copper CMP processing is desired, it is usually important that the removal rate of the metal and barrier layer material be significantly higher than the removal rate for dielectric material in order to avoid or minimize dishing of metal features or erosion of the dielectric. Alternatively, a multi-step copper CMP process may be employed involving the initial removal and planarization of the copper overburden, referred to as a step 1 copper CMP process, followed by a barrier layer CMP process. The barrier layer CMP process is frequently referred to as a barrier or step 2 copper CMP process. Previously, it was believed that the removal rate of the copper and the adhesion-promoting layer and/or the diffusion barrier layer must both greatly exceed the removal rate of dielectric so that polishing effectively stops when elevated portions of the dielectric are exposed. The ratio of the removal rate of copper to the removal rate of dielectric base is called the "selectivity" for removal of copper in relation to dielectric during CMP processing of substrates comprised of copper, tantalum and dielectric material. The ratio of the removal rate of tantalum to the removal rate of dielectric base is called the "selectivity" for removal of tantalum in relation to dielectric during CMP processing. When CMP slurries with high selectivity for removal of copper and tantalum in relation to dielectric are used, the copper layers are easily over-polished creating a depression or "dishing" effect in the copper vias and trenches. This feature distortion is unacceptable due to lithographic and other constraints in semiconductor manufacturing.

Another feature distortion that is unsuitable for semiconductor manufacturing is called "erosion." Erosion is the topography difference between a field of dielectric and a dense array of copper vias or trenches. In CMP, the materials in the dense array maybe removed or eroded at a faster rate than the surrounding field of dielectric. This causes a topography difference between the field of dielectric and the dense copper array.

A typically used CMP slurry has two actions, a chemical component and a mechanical component. An important consideration in slurry selection is "passive etch rate." The passive etch rate is the rate at which copper is dissolved by the chemical component alone and should be significantly lower than the removal rate when both the chemical component and the mechanical component are involved. A large passive etch rate leads to dishing of the copper trenches and copper vias, and thus, preferably, the passive etch rate is less than 10 nanometers per minute.

During chemical mechanical planarization of copper, defects such as deposition of undesired particles and surface roughness can result. Some specific defect types include haze, pits, scratches, mounds, dimples, and stacking faults. A number of slurry composition systems for CMP of copper for reducing defectivity have been disclosed using different types of abrasive particles. For example , U.S patent 5,527,423 to Neville, et al. describes the use of fumed or precipitated silica or alumina. As these abrasive particles have a tendency to agglomerte over time, agglomeration can produce scratching defects during polishing. Also abrasives particles such as alumina are hard, this can result in micro-scratching of copper during polishing. Hence use of colloidal silica is preferred in the preparation of slurries. For example, U.S. application 2005/0113,000, and U.S. patent 6,964,600 to I. Belov et al. describe the use of colloidal silica slurry for chemical mechanical polishing. Even though colloidal silica offers many advantages in slurry formulations for chemical mechanical planarization of copper, one disadvantage of standard colloidal silica is that it contains soluble polymeric silicates. These soluble polymeric silicates are formed during the manufacture of colloidal silica. The soluble polymeric silicates can complex with copper during polishing of copper-containing substrates. This complexation can result in defects such as scratching, pits, and organo-copper particles.

In relation to copper CMP, the current state of this technology involves use of a two-step process to achieve local and global planarization in the production of IC chips. During step 1 of a copper CMP process, the overburden copper is removed. Then step 2 of the copper CMP process follows to remove the barrier layer and achieve both local and global planarization. Generally, after removal of overburden copper in step 1, polished wafer surfaces have non-uniform local and global planarity due to differences in the step heights at various locations of the wafer surfaces. Low density features tend to have higher copper step heights whereas high density features tend to have low step heights. Due to differences in the step heights after step 1, step 2 copper CMP selective slurries with respect to tantalum to copper removal rates and copper to oxide removal rates are highly desirable. The ratio of the removal rate of tantalum to the removal rate of copper is called the "selectivity" for removal of tantalum in relation to copper during CMP processing of substrates comprised of copper, tantalum and dielectric material.

There are a number of theories as to the mechanism for chemical-mechanical polishing of copper. An article by D. Zeidler, Z. Stavreva, M. Ploetner, K. Drescher, "Characterization of Cu Chemical Mechanical Polishing by Electrochemical Investigations" (Microelectronic Engineering, 33(104), 259-265 (English) 1997), proposes that the chemical component forms a passivation layer on the copper changing the copper to a copper oxide. The copper oxide has different mechanical properties, such as density and hardness, than metallic copper and passivation changes the polishing rate of the abrasive portion. The above article by Gutmann, et al., entitled "Chemical-Mechanical Polishing of Copper with Oxide and Polymer Interlevel Dielectrics" (Thin Solid Films, 1995), discloses that the mechanical component abrades elevated portions of copper and the chemical component then dissolves the abraded material. The chemical component also passivates recessed copper areas minimizing dissolution of those portions.

These are two general types of layers that can be polished. The first layer is interlayer dielectrics (ILD), such as silicon oxide and silicon nitride. The second layer is metal layers such as tungsten, copper, aluminum, etc., which are used to connect the active devices.

In the case of CMP of metals, the chemical action is generally considered to take one of two forms. In the first mechanism, the chemicals in the solution react with the metal layer to continuously form an oxide layer on the surface of the metal. This generally requires the addition of an oxidizer to the solution such as hydrogen peroxide, ferric nitrate, etc. Then the mechanical abrasive action of the particles continuously and simultaneously removes this oxide layer. A judicious balance of these two processes obtains optimum results in terms of removal rate and polished surface quality.

In the second mechanism, no protective oxide layer is formed. Instead, the constituents in the solution chemically attack and dissolve the metal, while the mechanical action is largely one of mechanically enhancing the dissolution rate by such processes as continuously exposing more surface area to chemical attack, raising the local temperature (which increases the dissolution rate) by the friction between the particles and the metal and enhancing the diffusion of reactants and products to and away from the surface by mixing and by reducing the thickness of the boundary layer.

While prior art CMP systems are capable of removing a copper overlayer from a silicon dioxide substrate, the systems do not satisfy the rigorous demands of the semiconductor industry. These requirements can be summarized as follows. First, there is a need for high removal rates of copper to satisfy throughput demands. Secondly, there must be excellent topography uniformity across the substrate. Finally, the CMP method must minimize defectivity levels on polished substrates that are imparted during polishing as well as local dishing and erosion effects to satisfy ever increasing lithographic demands.

U.S. Patent 6,979,252 discloses the importance of using colloidal silica-based slurries having low levels of soluble polymeric silicates as abrasives in these slurries in order to realize low defectivity levels during CMP processing or other processing. There are several aspects to the '252 patent. In one aspect, the '252 patent provides a method for separating and removing soluble polymeric silicates in a colloidal silica polishing slurry prior to a CMP process; this method involves centrifugation of a polishing slurry to afford a product slurry in which the product slurry has a lower level of soluble polymeric silicates (and lower defectivity level) than does the polishing slurry. In another aspect, the '252 patent provides a product slurry prepared according to the aforementioned method from a polishing slurry; this product slurry has a lower level of soluble polymeric silicates than does the polishing slurry. Consequently, this product slurry affords lower defectivity levels during CMP processing or other processing than does the polishing slurry. A third aspect of the '252 patent entails use of a product slurry prepared according to the aforementioned method in a chemical mechanical polishing slurry instead of polishing slurry, such that use of the product slurry affords a lower number of post polish defects than does use of the polishing slurry. The '252 patent has examples that are all focused on oxide CMP; there are no examples on metal CMP, including no examples on copper CMP in particular.

There is a significant need for copper CMP process(es) with colloidal silica slurries that afford low defectivity levels on copper surfaces during polishing with these slurries. The present invention provides a solution to this significant need.

### BRIEF SUMMARY OF THE INVENTION

In an embodiment, the invention is a composition for chemical mechanical planarization of a surface having at least one feature thereon comprising copper, said composition comprising colloidal silica that is substantially free of soluble polymeric silicates.

In another embodiment, the invention is a method for chemical mechanical planarization of a surface having at least one feature thereon comprising copper, said method comprising the steps of:
A) placing a substrate having the surface having the at least one feature thereon comprising copper in contact with a polishing pad;
B) delivering a polishing composition comprising colloidal silica that is substantially free of soluble polymeric silicates; and
C) polishing the substrate with the polishing composition.

In yet another embodiment, the invention is a method for chemical mechanical planarization of a surface having at least one feature thereon comprising copper, said method comprising the steps of:
A) placing a substrate having the surface having the at least one feature thereon comprising copper in contact with a polishing pad;
B) delivering a polishing composition comprising:
   a) colloidal silica that is substantially free of soluble polymeric silicates; and
   b) an oxidizing agent. and
C) polishing the substrate with the polishing composition.

### DETAILED DESCRIPTION OF THE INVENTION

This invention involves compositions comprising colloidal silica that are substantially free of soluble polymeric silicates. Such compositions have been surprisingly and unexpectedly found to afford much lower post-CMP defect levels on copper surfaces in comparison to (previously disclosed) defect levels on oxide surfaces. For this reason especially, these compositions are very desirable for use as slurries for copper and other metal chemical mechanical polishing (CMP). This invention also involves associated methods for metal (e.g., copper) CMP processing using these compositions. In an embodiment, the term "substantially free of soluble polymeric silicates" means that the level of soluble polymeric silicates in the colloidal silica is less than or equal to 0.5 weight percent. In another embodiment, this term means that the level of soluble polymeric silicates in the colloidal silica is less than or equal to 0.25 weight percent. In another embodiment, this term means that the level of soluble polymeric silicates in the colloidal silica is less than or equal to 0.1 weight percent. In another embodiment, this term means that the level of soluble polymeric silicates in the colloidal silica is less than or equal to 0.05 weight percent. In another embodiment, this term means that the level of soluble polymeric silicates in the colloidal silica is less than or equal to 0.01 weight percent. In another embodiment, this term means that the level of soluble polymeric silicates in the colloidal silica is less than or equal to 0.001 weight percent.

In an embodiment, the compositions and associated methods of this invention will afford at least a 75% reduction in defect levels incurred during copper CMP in relation to those obtained using normal colloidal silica that has not been treated for removal of any soluble polymeric silicates. In another embodiment, the compositions and associated methods of this invention will afford at least a 90% reduction in defect levels incurred during copper CMP in relation to those obtained using normal colloidal silica that has not been treated for removal of any soluble polymeric silicates. In another embodiment, the compositions and associated methods of this invention will afford at least a 95% reduction in defect levels incurred during copper CMP in relation to those obtained using normal colloidal silica that has not been treated for removal of any soluble polymeric silicates. In another embodiment, the compositions and associated methods of this invention will afford at least a 97% reduction in defect levels incurred during copper CMP in relation to those obtained using normal colloidal silica that has not been treated for removal of any soluble polymeric silicates. In another embodiment, the compositions and associated methods of this invention will afford at least a 98% reduction in defect levels incurred during copper CMP in relation to those obtained using normal colloidal silica that has not been treated for removal of any soluble polymeric silicates.

The colloidal silica abrasive is present in the slurry in a concentration of 1 weight % to 25 weight % of the total weight of the slurry. More preferably, the abrasive is present in a concentration of 4 weight % to 20 weight % of the total weight of the slurry. Most preferably, the abrasive is present in a concentration of 5 weight % to 10 weight % of the total weight of the slurry.

In embodiments of this invention having an oxidizing agent, the oxidizing agent can be any suitable oxidizing agent. Suitable oxidizing agents include, for example, one or more per-compounds, which comprise at least one peroxy group (-O-O-). Suitable per-compounds include, for example, peroxides, persulfates (e.g., monopersulfates and dipersulfates), percarbonates, and acids thereof, and salts thereof, and mixtures thereof. Other suitable oxidizing agents include, for example, oxidized halides (e.g., chlorates, bromates, iodates, perchlorates, perbromates, periodates, and acids thereof, and mixtures thereof, and the like), perboric acid, perborates, percarbonates, peroxyacids (e.g., peracetic acid, perbenzoic acid, m-chloroperbenzoic acid, salts thereof, mixtures thereof, and the like), permanganates, chromates, cerium compounds, ferricyanides (e.g., potassium ferricyanide), mixtures thereof, and the like. Preferred oxidizing agents include, for example, hydrogen peroxide, urea-hydrogen peroxide, sodium peroxide, benzyl peroxide, di-t-butyl peroxide, peracetic acid, monopersulfuric acid, dipersulfuric acid, iodic acid, and salts thereof, and mixtures thereof.

In this invention, (hydrogen peroxide) H₂O₂ is used as a preferred oxidizing agent. When used, preferably the concentration of the H₂O₂ is from 0.2 weight % to 5 weight % of the total weight of the slurry.

Other chemicals that may be added to the CMP slurry composition include, for example, surfactants, pH-adjusting agents, acids, corrosion inhibitors, fluorine-containing compounds, chelating agents, nitrogen-containing compounds, and salts.

Suitable surfactant compounds that may be added to the slurry composition include, for example, any of the numerous nonionic, anionic, cationic or amphoteric surfactants known to those skilled in the art. The surfactant compounds may be present in the slurry composition in a concentration of 0 weight % to 1 weight % and are preferably present in a concentration of 0.001 weight % to 0.1 weight % of the total weight of the slurry. The preferred types of surfactants are nonionic, anionic, or mixtures thereof and are most preferably present in a concentration of 10 ppm to 1000 ppm of the total weight of the slurry. Nonionic surfactants are most preferred. A preferred nonionic surfactant is Surfynol^{™} 104E, which is a 50:50 mixture by weight of 2,4,7,9-tetramethyl-5-decyn-4,7-diol and ethylene glycol (solvent), (Air Products and Chemicals, Allentown, PA).

The pH-adjusting agent is used to improve the stability of the polishing composition, to improve the safety in handling and use, or to meet the requirements of various regulations. Suitable pH-adjusting agents to lower the pH of the polishing composition of the present invention include, but are not limited to, hydrochloric acid, nitric acid, sulfuric acid, chloroacetic acid, tartaric acid, succinic acid, citric acid, malic acid, malonic acid, various fatty acids, various polycarboxylic acids and mixtures thereof. Suitable pH-adjusting agents to raise the pH of the polishing composition of the present invention include, but are not limited to, potassium hydroxide, sodium hydroxide, ammonia, tetramethylammonium hydroxide, ethylenediamine, piperazine, polyethyleneimine, modified polyethyleneimines, and mixtures thereof..

The polishing composition of the present invention is not particularly limited with respect to the pH and broadly can range from pH 6 to pH 12. For metal CMP applications, compositions having basic or neutral pH values are generally preferred according to this invention. Accordingly for most metal (e.g., copper) CMP applications, a suitable slurry pH is 6.5 to 10, preferably from 8 to 12, and more preferably, from 10 to 12.

Suitable acid compounds that may be added to the slurry composition include, but are not limited to, formic acid, acetic acid, propanoic acid, butanoic acid, pentanoic acid, hexanoic acid, heptanoic acid, octanoic acid, nonanoic acid, lactic acid, hydrochloric acid, nitric acid, phosphoric acid, sulfuric acid, hydrofluoric acid, malic acid, tartaric acid, gluconic acid, citric acid, phthalic acid, pyrocatechoic acid, pyrogallol carboxylic acid, gallic acid, tannic acid, and mixtures thereof. These acid compounds may be present in the slurry composition in a concentration of 0 weight % to 1 weight % of the total weight of the slurry.

To increase the removal rates of the slurry for tantalum and tantalum compounds as well as copper relative to silicon dioxide, fluorine-containing compounds may be added to the slurry composition. Suitable fluorine-containing compounds include, but are not limited to, hydrogen fluoride, perfluoric acid, alkali metal fluoride salt, alkaline earth metal fluoride salt, ammonium fluoride, tetramethylammonium fluoride, ammonium bifluoride, ethylenediammonium difluoride, diethylenetriammonium trifluoride, and mixtures thereof. The fluorine-containing compounds may be present in the slurry composition in a concentration of 0 weight % to 5 weight %, and are preferably present in a concentration of 0.10 weight % to 2 weight % of the total weight of the slurry. The preferred fluorine-containing compound is ammonium fluoride, most preferably present in a concentration of 0 weight % to 1 weight % of the total weight of the slurry.

Suitable chelating agents that may be added to the slurry composition include, but are not limited to, ethylenediaminetetracetic acid (EDTA), N-hydroxyethylethylenediaminetriacetic acid (NHEDTA), nitrilotriacetic acid (NTA), diethylenetriaminepentacetic acid (DPTA), ethanoldiglycinate, tricine, and mixtures thereof. The chelating agents may be present in the slurry composition in a concentration of 0 weight % to 3 weight %, and are preferably present in a concentration of 0.05 weight % to 0.20 weight % of the total weight of the slurry. Preferred chelating agents are tricine and EDTA and are most preferably present in a concentration of 0.05 weight % to 0.20 weight % of the total weight of the slurry.

Suitable nitrogen-containing compounds that may be added to the slurry composition include, but are not limited to, ammonium hydroxide, hydroxylamine, monoethanolamine, diethanolamine, triethanolamine, diethyleneglycolamine, N-hydroxylethylpiperazine, polyethyleneimine, modified polyethyleneimines, and mixtures thereof. The nitrogen-containing compounds may be present in the slurry composition in a concentration of 0 weight % to 1 weight %, and are preferably present in a concentration of 0.01 weight % to 0.20 weight % of the total weight of the slurry. The preferred nitrogen-containing compound is ammonium hydroxide and is most preferably present in a concentration of 0.01 weight % to 0.1 weight % of the total weight of the slurry.

Suitable salts that may be added to the slurry composition include, but are not limited to, ammonium persulfate, potassium persulfate, potassium sulfite, potassium carbonate, ammonium nitrate, potassium hydrogen phthalate, hydroxylamine sulfate, and mixtures thereof. The salts may be present in the slurry composition in a concentration of 0 weight % to 10 weight %, and are preferably present in a concentration of 0 weight % to 5 weight % of the total weight of the slurry. A preferred salt is ammonium nitrate and is most preferably present in a concentration of 0 weight % to 0.15 weight % of the total weight of the slurry.

Still other chemicals that can be added to the slurry compositions are biological agents such as bactericides, biocides and fungicides especially if the pH is around 6 to 9. Suitable biocides, include, but are not limited to, 1,2-benzisothiazolin-3-one; 2( hydroxymethyl)amino ethanol; 1,3-dihydroxymethyl-5,5dimethylhydantoin; 1-hydroxymethyl-5,5-dimethylhydantion; 3-iodo-2-propynyl butylcarbamate; glutaraldehyde; 1,2-dibromo-2,4-dicyanobutane; 5-chloro-2-methyl-4-isothiazoline-3-one; 2-methyl-4-isothiazolin-3-one; and mixtures thereof.

### Associated Method

The associated methods of this invention entail use of the aforementioned composition (as disclosed supra) for chemical mechanical planarization of substrates comprised of metals and dielectric materials. In the methods, a substrate (e.g., a wafer) is placed face-down on a polishing pad which is fixedly attached to a rotatable platen of a CMP polisher. In this manner, the substrate to be polished and planarized is placed in direct contact with the polishing pad. A wafer carrier system or polishing head is used to hold the substrate in place and to apply a downward pressure against the backside of the substrate during CMP processing while the platen and the substrate are rotated. The polishing composition (slurry) is applied (usually continuously) on the pad during CMP processing to effect the removal of material to planarize the substrate.

The slurry composition and associated methods of this invention are effective for CMP of a wide variety of substrates, including substrates having dielectric portions that comprise materials having dielectric constants less than 3.3 (low-k materials). Suitable low-k films in substrates include, but are not limited to, organic polymers, carbon-doped oxides, fluorinated silicon glass (FSG), inorganic porous oxide-like materials, and hybrid organic-inorganic materials. Representative low-k materials and deposition methods for these materials are summarized below.

| Vendor | Trade Name | Deposition Method | Material |
|---|---|---|---|
| Air Products and Chemicals | MesoElk^{™} | Spin-on | Hybrid organic-inorganic |
| Applied Materials | Black Diamond | CVD | Carbon-doped oxide |
| Dow Chemical | SiLK^{™}, Porous SiLK^{™} | Spin-on | Organic polymer |
| Honeywell Electronic Materials | NANOGLASS^{™} E | Spin-on | Inorganic oxide-like |
| Novellus Systems | CORAL^{™} | PECVD | Carbon-doped oxide |

| | | | |
|---|---|---|---|
| PECVD = Plasma enhanced chemical vapor deposition CVD = chemical vapor deposition | | | |

Current copper CMP technology uses a two-step process to achieve local and global planarization in the production of IC chips. During copper CMP in step 1, the overburden copper is removed during IC fabrication processing. After removing the overburden copper in step 1, the polished surface still has not achieved local and global planarity due to differences in the step heights between high density and low density features on pattern wafers. After removing the overburden copper in step 1, a high tantalum to copper selectivity is desired to achieve local and global planarization. A challenging task is to maintain high tantalum removal while achieving high tantalum to copper selectivity and protection of the low lying copper regions. If the low lying copper regions are not protected during polishing, this results in a defect commonly known as "dishing". A slurry which can increase the tantalum to copper selectivity during polishing in step 2 can reduce "dishing" by providing wide overpolish window during chip fabrication processing.

The present invention is further demonstrated by the examples below.

### GLOSSARY

### COMPONENTS

- Colloidal silica: Syton^{™} OX-K (DuPont Air Products NanoMaterials L.L.C.,Tempe, AZ) colloidal silica.
- Colloidal silica: Uncentrifuged potassium stabilized silica, DP246 (DuPont Air Products NanoMaterials L.L.C.,Tempe, AZ) colloidal silica having 60-75 nm particles.
- Colloidal silica: Centrifuged potassium stabilized silica, DP290, (DuPont Air Products NanoMaterials L.L.C.,Tempe, AZ) colloidal silica having 60-75 nm particles.
- Zonyl^{™} FSN: Fluorinated surfactant (E.I. DuPont de Nemours, Wilmington, DE) Zonyl FSN^{™} is a non-ionic surfactant, and a mixture of telomeric monoether with polyethylene glycol; the structure is as follows:

R_{f}CH₂CH₂O(CH₂CH₂O)ₓH :

Where R_{f} = F (CF2CF2)y
x = 0 to about 25
y= 1 to about 9
- PETEOS: Plasma enhanced deposition of tetraethoxy silane, dielectric oxide layer.
- Polishing Pad: Polishing pad , Politex^{™}, and IC1000 were used during CMP, supplied by Rodel, Inc, Phoenix, AZ.
- TEOS: Tetraethyl orthosilicate

### PARAMETERS

### General

A: angstrom(s) - a unit of length (1 Å = 0.1 nm)
BP: back pressure, in psi units
CMP: chemical mechanical planarization = chemical mechanical polishing
CS: carrier speed
DF: Down force: pressure applied during CMP, units psi
min: minute(s)
ml: milliliter(s)
mV: millivolt(s)
psi: pounds per square inch (1 psi = 6.9 kPa)
PS: platen rotational speed of polishing tool, in rpm (revolution(s) per minute)
SF: slurry flow, ml/min

### Removal Rates and Selectivities

- Cu RR 2 psi: Measured copper removal rate at 2 psi (13.8 kPa) down pressure of the CMP tool
- Ta RR 2 psi: Measured tantalum removal rate at 2 psi (13.8 kPa) down pressure of the CMP tool
- TEOS RR 2 psi: Measured TEOS removal rate at 2 psi (13.8 kPa) down pressure of the CMP tool
- PETEOS RR 2 psi: Measured PETEOS removal rate at 2 psi (13.8 kPa) down pressure of the CMP tool

### EXAMPLES

### General

All percentages are weight percentages unless otherwise indicated.

### CMP Methodology

In the examples presented below, CMP experiments were run using the procedures and experimental conditions given below.

### Metrology

PETEOS thickness was measured with an oxide thickness measuring instrument, Nanometrics, model, #9200, manufactured by Nanometrics Inc, 1550 Buckeye, Milpitas, CA 95035-7418. The metal films were measured with a metal thickness measuring instrument, ResMap CDE, model 168, manufactured by Creative Design Engineering, Inc, 20565 Alves Dr, Cupertino, CA, 95014. The ResMap tool is a four-point probe sheet resistance tool. Twenty-five and forty nine-point polar scans were taken with the respective tools at 3-mm edge exclusion.

### CMP Tool

The CMP tool that was used is a Mirra^{™}, manufactured by Applied Materials, 3050 Boweres Avenue, Santa Clara, California, 95054. A Rodel Politex^{™} embossed pad, supplied by Rodel, Inc, 3804 East Watkins Street, Phoenix, AZ, 85034, was used on the platen for the blanket wafer polishing studies. Pads were broken-in by polishing twenty-five dummy oxide (deposited by plasma enhanced CVD from a TEOS precursor, PETEOS) wafers. In order to qualify the tool settings and the pad break-in, two PETEOS monitors were polished with Syton^{™} OX-K colloidal silica, supplied by DuPont Air Products NanoMaterials L.L.C., at baseline conditions.

In blanket wafers studies, groupings were made to simulate successive film removal: first copper, next tantalum, and finally the PETEOS. The tool mid-point conditions were: table speed; 123 rpm, head speed; 112 rpm, membrane pressure, 2.0 psi (13.8 kPa); inter-tube pressure, 0.0 psi (0.0 kPa); slurry flow, 200 ml/min Defect counts were measured using a Surfscan^{™} SP1 instrument manufactured by KLA Tencore, located at 1-Technology Drive, Milipita, CA, 95035. This instrument is a laser-based wafer surface inspection system. Using this instrument, particles and surface defects on unpatterned substrates were obtained. The particle count was recorded as number of defects, location of defects, and the size of defects. Also, this instrument was used for measuring surface quality through characterization of surface roughness and classification of defects such as haze, pits, scratches, mounds, dimples, and stacking faults. Experiments were done by loading the wafers under vacuum wand into a cassette, followed by placing the cassette on the SP1 instrument using a Novellus^{™} copper calibration standard. This method classifies defects ranging from 0.2 micron to 2.5 micron. The sum of all defect values was recorded as post CMP defects as reported in Table 1.

### Wafers

Polishing experiments were conducted using electrochemically deposited copper, tantalum, and PETEOS wafers. These blanket wafers were purchased from Silicon Valley Microelectronics, 1150 Campbell Ave, CA, 95126. The film thickness specifications are summarized below:
PETEOS: 15,000 Å on silicon
Copper: 10,000 Å electroplated copper/1,000 Å copper seed/250 Å Ta on silicon
Tantalum: 2000 Å /5,000 Å thermal oxide on silicon

### Example 1 (Comparative) and Examples 2-4

### Example 1

Components of mixture for preparing 3 kg of formulated slurry
1) Potassium carbonate (45% solution) = 93.33 grams
2) Uncentrifuged potassium stabilized colloidal silica (30% solids) = 500 grams
3) Citric acid (10% solution) = 183 grams
4) Potassium hydroxide (10% solution) = 177 grams
5) Hydrogen peroxide (30% solution) = 300 grams

### Procedure for mixing the slurry, 3 kg batch size

In a 5-liter beaker, 93.33 grams of potassium carbonate were added to 1746.7 grams of deionized water and allowed to stir using a magnetic stirrer for 2 minutes. Under agitation, 500 grams of uncentrifuged potassium stabilized colloidal silica were added slowly during a period of 2 minutes. After allowing the mixture to stir for 5 minutes, 183 grams of citric acid were added slowly. After 2 minutes of stirring, 177 grams of potassium hydroxide were added and allowed to stir for an additional 2 minutes. Three hundred grams of hydrogen peroxide were added directly before polishing.

### Example 2

This example with centrifuged potassium stabilized colloidal silica is for comparison with Example 1 (Comparative). The formulation is the same as described in Example 1, except that potassium stabilized centrifuged silica, DP-290, replaces uncentrifuged potassium stabilized silica, DP-246. The components are summarized below:
1) Deionized water = 1646.7 grams
2) Potassium carbonate (45% solution) = 93.33 grams
3) Potassium stabilized centrifuged colloidal silica, DP-290, (25% solids) = 600 grams; supplied by DuPont Air Products NanoMaterials, L.L.C., AZ
4) Citric acid (10% solution) = 183 grams
5) Potassium hydroxide (10% solution) = 177 grams
6) Hydrogen peroxide (30% solution) = 300 grams
Total weight = 3000 grams

### Example 3

This example with Zonyl^{™} FSN is for comparison with Example 1. The formulation is the same as described in Example 1, except that Zonyl^{™} FSN is present. The components are summarized below:
1) Deionized water = 1740.7 grams
2) Potassium carbonate (45% solution) = 93.33 grams
3) Uncentrifuged potassium stabilized colloidal silica (30% solids) = 500 grams
4) Citric acid (10% solution) = 183 grams
5) Potassium hydroxide (10% solution) = 177 grams
6) Zonyl^{™} FSN (100%) = 6 grams
7) Hydrogen peroxide (30% solution) = 300 grams
Total weight = 3000 grams

### Example 4

This example with centrifuged potassium stabilized colloidal silica is for comparison with Example 2. The formulation is the same as described in Example 2, except that Zonyl^{™} FSN is present. The components are summarized below:
1) Deionized water = 1640.7 grams
2) Potassium carbonate (45% solution) = 93.33 grams
3) Centrifuged potassium stabilized colloidal silica, DP290 (25% solids) = 600 grams; supplied by DuPont Air Products NanoMaterials, L.L.C., AZ
4) Citric acid (10% solution) = 183 grams
5) Potassium hydroxide (10% solution) = 177 grams
6) Zonyl^{™} FSN (100%) = 6 grams
7) Hydrogen peroxide (30% solution) = 300 grams
Total weight = 3000 grams

The results obtained for Examples 1-4 are summarized in Table 1. As shown in this table, use in a CMP slurry of colloidal silica abrasive having soluble polysilicates removed resulted in a dramatic reduction in defectivity count on a post-CMP processed copper surface in comparison to use of comparable colloidal silica having soluble polysilicates present. Specifically, the defect count was reduced from 5898 (Comparative Example 1) to 89 (Example 2). Use of a comparable colloidal silica containing soluble polysilicates and having added surfactant gave a modest reduction in the defectivity count from 5898 (Example 1) to 5402 (Example 3). Use of a comparable colloidal silica having soluble polysilicates removed along with an added surfactant gave an even further decrease in defectivity count on copper from 89 (Example 2) to 60 (Example 4).

**Table 1: Effect of Removing Soluble Polymeric Silicates Using Centrifuge, from Colloidal Silica on Copper Defectivity, Copper, Tantalum, Black diamond, and PETEOS Removal Rates**

| Sample | Example 1: Comparative, Soluble polymeric silicates "present" in the silica abrasive (Uncentrifuged silica) | Example 2: Soluble polymeric silicates "removed " from colloidal silica abrasive, (Centrifuged silica) | Example 3: Soluble polymeric silicates "present" with surfactant Zonyl^{™} FSN (Uncentrifuge d silica) | Example 4: Soluble polymeric silicates "removed" from colloidal silica with surfactant Zonyl^{™} FSN (Centrifuged silica) |
|---|---|---|---|---|
| Silica^{a} ,wt. % | 5 | 5 | 5 | 5 |
| Citric acid, wt. % | 0.61 | 0.61 | 0.61 | 0.61 |
| Potassium carbonate, wt. % | 1.4 | 1. 4 | 1.4 | 1.4 |
| Potassium hydroxide, wt. % | 0.59 | 0.59 | 0.59 | 0.59 |
| Deionized water | Balance | Balance | Balance | Balance |
| Hydrogen peroxide (H₂O₂), wt. % | 3 | 3 | | 3 |
| pH before adding H₂O₂ | 10.8 | 11.1 | 11.2 | 11.12 |
| Copper removal rate^{b} at 2PSI (13.8 kPa) | 509 | 504 | 476 | 457 |
| Tantalum removal rate^{b} at 2PSI (13.8 kPa) | 635 | 750 | 582 | 750 |
| Black Diamond^{™} removal rate^{b} at 2 PSI (13.8 kPa) | 627 | 764 | 46 | 70 |
| PETEOS removal rate^{b} at 2PSI (13.8 kPa) | 370 | 401 | 262 | 349 |
| Post CMP oxide defects (0.13 micron)^{c} | 182 | 157 | 299 | 60 |
| Post CMP Copper defects (0.3 micron)^{d} | 5898 | 89 | 5402 | 60 |

| | | | | |
|---|---|---|---|---|
| ^{a}Silica used in Examples 1 and 3 was uncentrifuged potassium stabilized silica, DP246. Silica used in Examples 2 and 4 was centrifuged potassium stabilized silica, DP290. ^{b}All removal rates are in units of angstroms/ minute (Å/min) (0.1 nm/min). ^{c}This row lists the number of defects of size greater than or equal to 0.13 micron measured on an oxide surface following CMP processing using the CMP slurry as listed above. ^{d}This row lists the number of defects of size greater than or equal to 0.3 micron measured on a copper surface following CMP processing using the CMP slurry as listed above. These defect measurements were done using the defect count test procedure using the KLA Tencor instrument (as described supra) on 3 wafers. | | | | |

Table 2 below reproduces a portion of Table 1 above to focus attention on a dramatic difference in defectivity levels on post-CMP copper versus oxide surfaces using colloidal silica as abrasive with and without soluble polymeric silicates for CMP processing. As is seen in this table, there is surprisingly a much greater effect depending on whether soluble polymeric silicates are present or not upon post-CMP defectivity levels for a copper surface in relation to an oxide surface. The measured difference in defectivity count on a copper surface is 5,809 versus just 25 on an oxide surface.

**Table 2: Comparison of Defects on Oxide and Copper Surface After Post-CMP Using Silica Abrasive With and Without Removing Soluble Polymeric Silicates -Slurry Components Same as Described in Table 1**

| Sample or Comment | Number of defects on oxide surface, 0.13 micron | Number of defects on copper surface, 0.3 micron |
|---|---|---|
| Soluble polymeric silicates present, No surfactant | 182 | 5898 |
| Soluble polymeric silicates absent, No surfactant | 157 | 89 |
| Difference in number of defects (Row 2 - Row 3) | 25 | 5809 |
| % Reduction of Defects | 13.7 | 98.5 |

While the invention has been described in combination with embodiments thereof, it is evident that many alternatives, modifications and variations will be apparent to those skilled in the art in light of the foregoing description. Accordingly, it is intended to embrace all such alternatives, modifications and variations as fall within the broad scope of the appended claims.

## Claims

1. A method for chemical mechanical planarization of a surface having at least one feature thereon comprising copper, said method comprising the steps of:
A) placing a substrate having the surface having the at least one feature thereon comprising copper in contact with a polishing pad;
B) delivering a polishing composition comprising colloidal silica that is substantially free of soluble polymeric silicates; and
C) polishing the substrate with the polishing composition.

2. A composition for chemical mechanical planarization of a surface having at least one feature thereon comprising copper, said composition comprising colloidal silica that is substantially free of soluble polymeric silicates.

3. The method or composition of Claim 1 or 2, wherein the composition comprising colloidal silica further comprises an oxidizing agent.

4. The method or composition of Claim 3 wherein the oxidizing agent is hydrogen peroxide.

5. The method or composition of any preceding claim, wherein the composition comprising colloidal silica further comprises a surfactant.

6. The method or composition of Claim 5 wherein the surfactant is a fluorosurfactant.

7. The method or composition of any preceding claim, wherein centrifugation has been employed to produce the colloidal silica that is substantially free of soluble polymeric silicates.
